Europäisches Patentamt

(19) European Patent Office

Office européen des brevets

(11) EP 0 806 675 A1

(12) DEMANDE DE BREVET EUROPEEN

(43) Date de publication:
12.11.1997 Bulletin 1997/46

(51) Int. Cl.⁶: $G01R\ 15/24$, $G01R\ 1/07$

(21) Numéro de dépôt: 97410045.5

(22) Date de dépôt: 25.04.1997

(84) Etats contractants désignés:
CH DE ES GB IT LI SE

(30) Priorité: 07.05.1996 FR 9606015

(71) Demandeur: SCHNEIDER ELECTRIC SA
92100 Boulogne Billancourt (FR)

(72) Inventeurs:
• Kevorkian, Antoine
38050 Grenoble Cedex 09 (FR)
• Persegol, Dominique
38050 Grenoble Cedex 09 (FR)
• Danel, Adrien
38050 Grenoble Cedex 09 (FR)

(74) Mandataire:
Jouvray, Marie-Andrée et al
Schneider Electric SA,
Sce. Propriété Industrielle
38050 Grenoble Cédex 09 (FR)

(54) Capteur de tension électro-optique à fibre optique

(57) Le capteur de tension comporte un bobinage hélicoïdal constitué par une fibre optique (12) ayant au moins une zone sensible ou sensibilisée au champ électrique présentant un effet électro-optique d'ordre 2. Le procédé de sensibilisation peut être réalisé par un procédé de polarisation sous champ. Le capteur comporte, de préférence, un dispositif (16, 17) permettant d'homogénéiser les lignes de champ électrique ($\vec{E}$) dans la région où est disposé le bobinage hélicoïdal. Le déphasage induit par l'onde optique par effet électro-optique, provoqué par le champ électrique et représentatif de la tension à mesurer, peut être mesuré par détection polarimétrique ou interférométrique.

Fig. 4

EP 0 806 675 A1

## Description

L'invention concerne un capteur de tension électro-optique, comportant des moyens de production d'une onde lumineuse incidente, un transducteur électro-optique présentant un effet électro-optique d'ordre 2 disposé dans un champ électrique généré par une tension à mesurer et comportant une entrée recevant l'onde lumineuse incidente et une sortie fournissant une onde lumineuse de sortie, des moyens isolants de support du transducteur, des moyens de détection optoélectroniques connectés à la sortie du transducteur, et des moyens électroniques de traitement connectés aux moyens de détection.

Les capteurs de tension électro-optiques connus utilisent généralement comme transducteur un cristal sensible au champ électrique. De tels cristaux présentent un effet électro-optique linéaire, d'ordre 2, dit effet Pockels. L'isolation galvanique est limitée par les faibles dimensions du cristal transducteur, typiquement de l'ordre du centimètre. Ces capteurs sont, en conséquence, mal appropriés à la mesure de tensions électriques très élevées, de plusieurs centaines de kilovolts par exemple. Pour des raisons de rigidité diélectrique du matériau transducteur, il n'est pas possible d'appliquer toute la tension à mesurer aux bornes du cristal. Pour la mesure de hautes tensions, les capteurs de ce type sont en conséquence combinés avec des diviseurs de tensions.

Un capteur électro-optique permettant la mesure d'une tension de 345 kV sans diviseur de tension a été décrit dans l'article "Application of an electro optic voltage transducer at 345 kV" présenté à "EPRI, Optical Sensors for Utility T & D Applications Workshop, Portland, Oregon, July 20-21,1995". Dans ce capteur, le transducteur est constitué par un cristal particulier, de grande dimension, présentant un effet électro-optique longitudinal. Un cristal de grande dimension est coûteux et la distance d'isolement de la tête du capteur est égale à la taille du cristal transducteur, ce qui nécessite une mise en oeuvre complexe et coûteuse pour assurer la tenue diélectrique du capteur dans un environnement haute tension.

L'invention a pour but un capteur de tension électro-optique ne présentant pas les inconvénients des capteurs connus.

Selon l'invention, ce but est atteint par le fait que le transducteur comporte une fibre optique ayant au moins une zone sensible ou sensibilisée au champ électrique et présentant un effet électro-optique d'ordre 2, ladite fibre étant disposée sous forme d'un bobinage entre deux points entre lesquels la tension à mesurer est appliquée. Le bobinage est de préférence hélicoïdal. Il peut également être constitué par une spirale.

Selon un développement de l'invention, le capteur comporte des moyens d'homogénéisation pour homogénéiser la distribution des lignes de champ électrique dans la région où sont disposées les zones sensibles de la fibre optique. Les moyens d'homogénéisation comportent, par exemple, deux électrodes planes, parallèles, aux bornes desquelles est appliquée la tension à mesurer.

Selon un autre développement de l'invention le bobinage est régulier et la fibre comporte des axes propres ayant une orientation sensiblement constante par rapport au champ électrique. Pour faciliter cette orientation, la fibre optique comporte, de préférence, des moyens externes de reconnaissance des axes propres de la fibre.

La mesure du déphasage induit par effet électro-optique peut être réalisée par une analyse polarimétrique. Le point de fonctionnement du capteur est alors, de préférence, asservi par des moyens de contrôle et de commande basse-fréquence de l'état de polarisation de l'onde lumineuse.

D'autres avantages et caractéristiques ressortiront plus clairement de la description suivante de différents modes de réalisation, donnés à titre d'exemples non limitatifs et représentés par les dessins annexés dans lesquels :

La figure 1 représente, sous forme schématique, un capteur de tension électro-optique de type connu.

La figure 2 illustre un tronçon de fibre optique sensible disposé dans un champ électrique externe.

La figure 3 représente un transducteur à fibre de forme linéaire.

La figure 4 représente un mode particulier de réalisation d'un transducteur utilisé dans un capteur selon l'invention.

Les figures 5 et 6 représentent les lignes de champ entre deux conducteurs, respectivement en l'absence et en présence d'électrodes planes.

La figure 7 représente, en coupe, une fibre optique comportant un méplat.

La figure 8 représente un mode particulier de réalisation d'un capteur selon l'invention.

La figure 9 illustre un bobinage en forme de spirale.

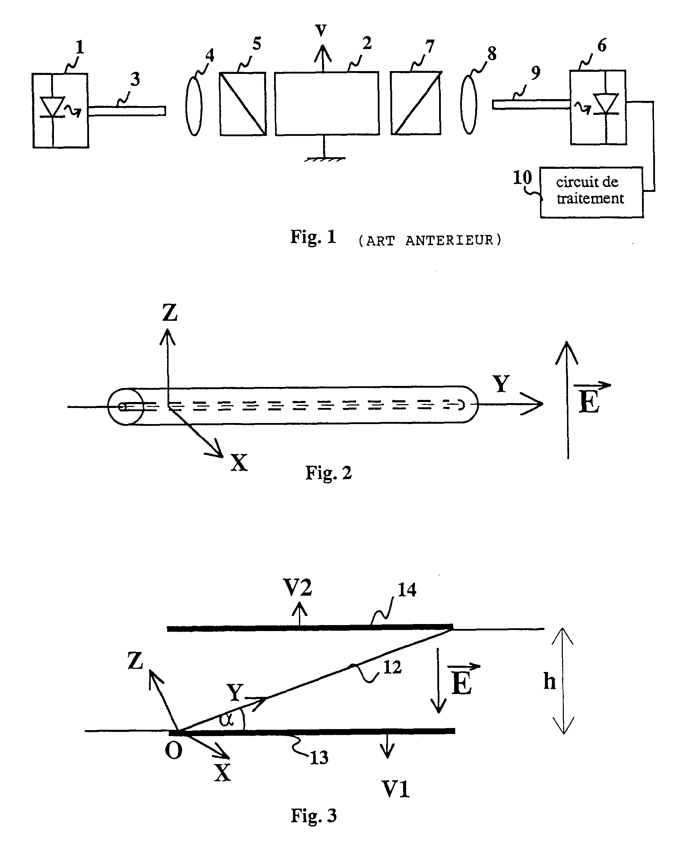

Le principe de la mesure de tension par un cristal électro-optique, de type connu, est représenté à la figure 1. Une source optique 1 fournit une onde lumineuse monochromatique. Celle-ci est transmise à l'entrée d'un cristal électro-optique 2 par l'intermédiaire d'une fibre optique d'entrée 3, d'une lentille 4 et d'un élément polariseur 5. L'onde lumineuse traverse le cristal 2 et est transmise à un détecteur optoélectronique 6 par l'intermédiaire d'un analyseur 7, constitué par un second élément polariseur, d'une lentille 8 et d'une fibre optique de sortie 9. La tension V à mesurer est appliquée entre deux faces du cristal 2 qui sont parallèles au sens de propagation de la lumière dans le cristal. Un circuit de traitement électronique 10 est connecté à la sortie du détecteur 6.

Un tel capteur fonctionne de la manière suivante :

Un champ électrique $\vec{E}$, crée par la tension V, induit dans le cristal 2 une anisotropie proportionnelle à $\|\vec{E}\|$. Sur la figure 1, l'effet électro-optique, ou effet Pockels, fonction linéaire du champ électrique, est dit transverse, le champ électrique étant perpendiculaire à la direction de propagation de la lumière dans le cristal. Le déphasage relatif accumulé au cours de la propagation dans le cristal entre les deux projections TE et TM du champ électrique de l'onde optique, sur les axes propres du cristal biréfringent est représentatif de la tension V appliquée aux bornes du cristal. Ce déphasage est mesuré polarimétriquement au moyen de l'analyseur 7. L'intensité de l'onde lumineuse en sortie de l'analyseur 7, représentative du déphasage, est transformée en signaux électriques par le détecteur 6, puis transmise au circuit de traitement 10 qui fournit un signal proportionnel à la tension V à mesurer.

Lorsque la tension à mesurer est élevée, elle ne peut être appliquée directement aux bornes du cristal. Un diviseur de tension, résistif ou capacitif, est alors utilisé.

L'effet électro-optique peut également être longitudinal. Dans ce cas le champ électrique induit par la tension à mesurer doit être sensiblement parallèle au sens de propagation de la lumière dans le cristal.

Selon l'invention le cristal électro-optique est remplacé par une fibre optique sensible. Or, une fibre optique ordinaire ne présente pas d'effet électro-optique d'ordre 2. Cependant il est possible, notamment grâce à des procédés de polarisation sous champ, par exemple par des techniques de "poling", de sensibiliser un tronçon de fibre optique de manière à ce qu'il présente des propriété électro-optique d'ordre 2 dans un région localisée près du coeur de la fibre.

Sur la figure 2, un tronçon de fibre 11 d'axe longitudinal Y, comporte après traitement de sensibilisation selon un axe Z, perpendiculaire à l'axe Y, des axes propres X, Y et Z, X et Z définissant un plan transverse à la direction de propagation de la lumière (axe Y). Dans ce cas l'effet électro-optique est transverse. L'anisotropie induite par effet électro-optique dépend des composantes du champ électrique à mesurer selon les axes propres de la fibre sensible. Dans le cas de la figure 2, l'anisotropie induite est maximale lorsque le champ électrique $\vec{E}$ dans lequel est placé la fibre est parallèle à l'axe Z. En effet, les propriétés électro-optiques de la fibre s'expriment sous la forme d'un tenseur, qui dans le système d'axe XYZ, s'écrit :

$$(1) \qquad [r] = \begin{bmatrix} 0 & 0 & r_{13} \\ 0 & 0 & r_{13} \\ 0 & 0 & r_{33} \\ 0 & r_{13} & 0 \\ r_{13} & 0 & 0 \\ 0 & 0 & 0 \end{bmatrix} \quad \text{avec } r_{33} = 3\, r_{13}$$

L'application d'un champ électrique externe $\vec{E}$ orienté selon Z conduit à une variation maximale d'indice de réfraction de la fibre. Cette variation vaut respectivement pour chaque axe :

$$\Delta n_x = \frac{1}{2} r_{13} n^3 \|\vec{E}\| \qquad\qquad (2)$$

$$\Delta n_z = \frac{1}{2} r_{33} n^3 \|\vec{E}\| = 3\, \Delta n_x \qquad\qquad (3)$$

où n est l'indice de réfraction moyen de la fibre et $\vec{E}$ est le champ électrique externe au niveau du coeur de la fibre.

Dans le cas où l'axe Z de la fibre sensible et le champ externe n'ont pas la même orientation, la variation d'indice de la fibre n'est pas maximale et l'ellipsoïde des indices résultant de l'effet électro-optique n'a plus l'orientation XYZ. Cependant, si la fibre sensible a une forte biréfringence intrinsèque (fibre HiBi), pour un désalignement inférieur à 90°, l'ellipsoïde des indice conserve les axes XYZ et les variations d'indice sur les axes X et Z sont données par les équations (2) et (3) où $\|\vec{E}\|$ est remplacé par Ez, Ez étant la composante selon Z du champ électrique externe. On utilisera, en conséquence, de préférence une fibre optique sensible à biréfringence intrinsèque élevée.

Le transducteur idéal se compose d'une fibre optique sensibilisée de manière uniforme sur toute sa longueur.

La tension correspondant à l'intégrale du champ électrique entre les points entre lesquels la tension est appliquée, le déphasage est directement représentatif de la tension lorsque l'onde lumineuse parcourt la totalité de la distance comprise entre ces points, c'est à dire si les extrémités du transducteur sont placées le plus près possible de ces deux points. Si le transducteur présente un effet électro-optique longitudinal, il est alors de préférence disposé suivant une droite reliant les deux points entre lesquels la tension à mesurer est appliquée. Par contre, si le transducteur présente un effet électro-optique transverse, comme c'est le cas de la fibre selon la figure 2, ce sont les composantes du champ situées dans le plan perpendiculaire à l'axe Y de propagation de la lumière qui sont responsables de l'anisotropie induite par effet électro-optique. La fibre ne peut alors être disposée parallèlement au champ suivant la droite reliant les deux points.

Selon un premier mode de réalisation représenté à la figure 3, une fibre optique 12 sensibilisée selon l'axe Z, de manière uniforme sur toute sa longueur, présente un effet électro-optique transverse. Elle constitue un transducteur linéaire. Un champ $\vec{E}$ uniforme est créé entre deux électrodes planes, parallèles, 13 et 14, portées à des potentiels différents, par exemple V1 et V2 respectivement. Les électrodes sont placées à une distance h l'une de l'autre. Pour mesurer la tension V = V2 - V1 , la fibre 12 est disposée selon une droite entre les deux électrodes planes, avec une pente prédéterminée, la fibre faisant un angle $\alpha$, constant, avec les électrodes. Sur la figure 3, la fibre est disposée de manière à ce que le champ $\vec{E}$ soit dans le plan formé par ses axes propres Y et Z. Dans le plan ZX, le champ $\vec{E}$ comporte alors une seule composante, non nulle, Ez responsable de l'anisotropie induite par effet électro-optique. L étant la longueur du tronçon de fibre disposé entre les électrodes, on peut montrer qu'entre les deux extrémités de la fibre, le déphasage total entre deux composantes orthogonales d'une onde lumineuse de longueur d'onde $\lambda$, lié à la variation d'indice de la fibre sensible due au champ électrique, s'exprime respectivement pour les deux ondes polarisées suivant les axes X et Z par :

$$\Phi_X = \frac{2\pi}{\lambda} \frac{1}{2} r_{13} n^3 \int_0^L Ez(Y)dY \tag{4}$$

$$\Phi_Z = \frac{2\pi}{\lambda} \frac{1}{2} r_{33} n^3 \int_0^L Ez(Y)dY \tag{5}$$

Or, pour un tronçon de fibre élémentaire dl, la composante Ez peut s'exprimer en fonction du champ local $\vec{E}$ (l) au point l considéré $(0 \leq l \leq L)$ par :

$$Ez = \|\vec{E}\,(1)\| \cos \alpha \tag{6}$$

l variant de 0 à L entre les extrémités du tronçon de fibre situées entre les électrodes. On définit un rapport k égal à L/h, de sorte que les équations (4) et (5) peuvent s'écrire

$$\Phi_x = \frac{\pi}{\lambda} r_{13} n^3 k \cos \alpha \int_0^h \|\vec{E}(1)\|dl \tag{7}$$

$$\Phi_z = \frac{\pi}{\lambda} r_{33} n^3 k \cos \alpha \int_0^h \|\vec{E}(1)\|dl \tag{8}$$

soit :

$$\Phi_x = \frac{\pi}{\lambda} r_{13} n^3 k \cos \alpha(V2 - V1) \tag{9}$$

$$\Phi_Z = \frac{\pi}{\lambda} r_{33} n^3 k \cos \alpha(V2 - V1) \tag{10}$$

Or $r_{33} = 3r_{13}$ (voir équation (1)).

A la sortie de la fibre, le déphasage électro-optique total entre les composantes de l'onde lumineuse selon les axes X et Z peut donc s'écrire :

$$\Phi eo = \Phi_Z - \Phi_X = \frac{2\pi}{\lambda} r_{13} n^3 k \cos \alpha(V2 - V1) \tag{11}$$

Ainsi, le déphasage induit par effet électro-optique entre les composantes de l'onde optique suivant les axes X et Z (axes propres de la fibre) est directement proportionnel à la différence de potentiel (V2-V1) à mesurer lorsque la fibre est disposée avec une pente et une orientation constantes par rapport au champ électrique $\vec{E}$.

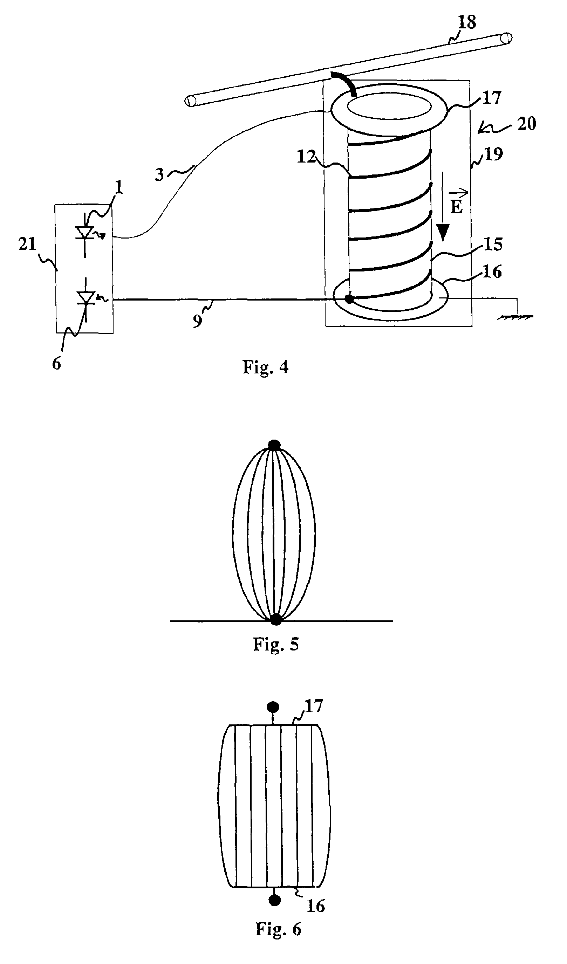

Selon un mode de réalisation préférentiel représenté à la figure 4, la fibre sensible constitue un transducteur de forme hélicoïdale. La fibre optique 12, sensibilisée selon l'axe Z de manière uniforme sur toute sa longueur, est bobinée sur un cylindre diélectrique 15. Deux électrodes planes 16 et 17, de forme circulaire, sont disposées aux deux extrémités du cylindre. La tension à mesurer est appliquée entre les deux électrodes, l'électrode 16 étant par exemple reliée à la terre et l'électrode 17 à une ligne haute tension 18. Le diamètre des électrodes est légèrement supérieur à celui du cylindre. Ainsi, dans la région où se trouve le cylindre, et en conséquence la fibre sensible, la répartition des lignes de champ est quasiuniforme (voir figure 6). La fibre est bobinée régulièrement le long du cylindre et l'orientation de ses axes propres est sensiblement constante par rapport au champ électrique $\vec{E}$. Dans ce cas, les formules précédentes restent applicables et le déphasage induit par effet électro-optique est proportionnel à l'intégrale du champ électrique, donc à la tension à mesurer. Des éléments polarisants, non représentés, sont disposés en entrée et en sortie du transducteur afin de polariser de manière appropriée l'onde lumineuse incidente et d'analyser l'onde lumineuse de sortie du transducteur. Une enveloppe diélectrique 19 protège l'ensemble de la tête du capteur 20. Un ensemble de mesure et de contrôle 21, comportant notamment la source lumineuse (1) ainsi que les moyens de détection (6) et de traitement électronique sont, de préférence, déportés de la tête du capteur à laquelle ils sont reliés par des fibres optiques d'entrée 3 et de sortie 9. Les liaisons entre la fibre sensible 12 et les fibres 3 et 9 peuvent être assurées, respectivement aux deux extrémités du cylindre, par de simples connexions optiques.

Le déphasage induit par effet électro-optique est proportionnel au nombre de tours du bobinage. Le cylindre diélectrique 15 peut servir de support aux électrodes 16 et 17. La fonction des électrodes 16 et 17 est plus particulièrement illustrée par les figures 5 et 6. Sur la figure 5, en l'absence des électrodes, les lignes de champ entre deux points de potentiel différents, ne sont pas rectilignes. Si une fibre sensible est disposée dans cette zone, son orientation par rapport au champ électrique varie d'un point à l'autre. Grâce aux électrodes planes 16 et 17 (figure 6) il y a homogénéisation des lignes de champ. La direction des lignes de champ est quasi-uniforme entre les électrodes qui constituent un condensateur plan dans lequel est placé le bobinage et dans lequel les lignes de champ électrique sont sensiblement parallèles à l'axe du bobinage. La direction du champ électrique étant constante, il est alors possible de disposer une fibre optique sensible dans ce champ avec une orientation prédéterminée des axes propres de la fibre par rapport au champ.

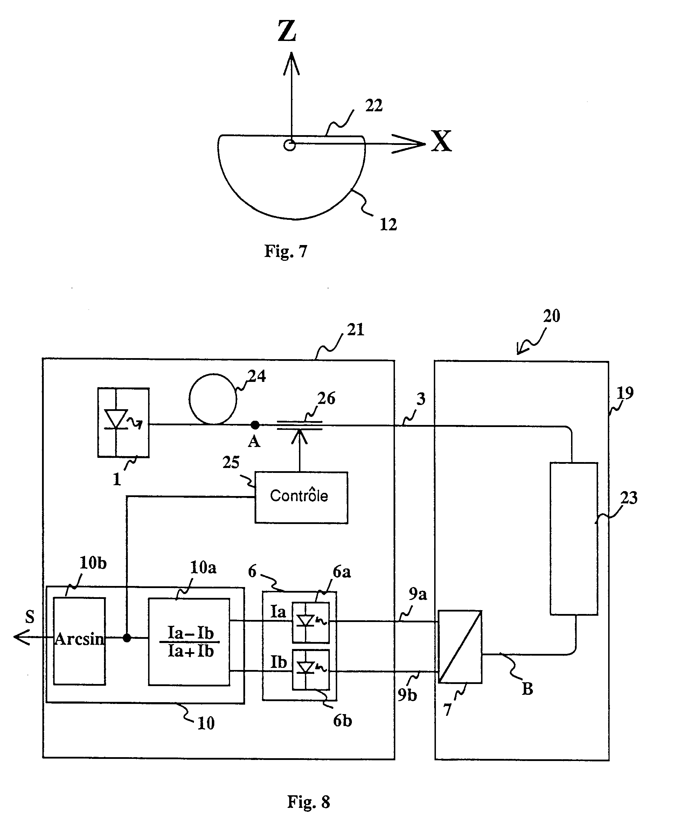

Selon un mode de réalisation particulier, représenté à la figure 7, la fibre optique comporte un méplat longitudinal 22. Le méplat 22 a une orientation prédéterminée par rapport aux axes propres de la fibre. Sur la figure le méplat 22 est perpendiculaire à l'axe Z de sensibilisation de la fibre. Ainsi, lors du bobinage de la fibre 12 sur le cylindre diélectrique 15, il est plus facile d'assurer le maintien des axes propres de la fibre dans une orientation prédéterminée constante, par rapport à l'axe du bobinage, c'est à dire par rapport à l'axe du cylindre et par rapport à la direction du champ électrique.

Toute méthode d'analyse d'une variation de l'état d'une onde lumineuse en sortie du transducteur, liée à la variation de l'indice de la zone sensible, ou des zones sensibles, du transducteur peut être utilisée. les méthodes de détection interférométrique ou polarimétrique, de type classique, sont par exemple utilisables.

A titre d'exemple, non limitatif, un mode de réalisation particulier du capteur de tension, utilisant une méthode d'analyse polarimétrique, va être décrite plus en détail au regard de la figure 8.

Comme sur la figure 4, le capteur comporte une tête de capteur 20 et un ensemble 21 de mesure et de contrôle relié à la tête de capteur 20 par des fibres optiques. Le transducteur, qui est de préférence du type représenté à la figure 4, est représenté de manière schématique en 23 à l'intérieur de la tête du capteur 20.

La source optique 1, disposée dans l'ensemble 21, fournit une onde lumineuse de longueur d'onde $\lambda$ et d'intensité Io. La source optique 1 est connectée à une fibre polarisante 24. On obtient ainsi à la sortie de la fibre polarisante, A, une lumière polarisée linéairement. Le point A est connecté par une fibre d'entrée 3 au transducteur 23. Sur la figure 8, la fibre 3 est une fibre à maintien de polarisation dont les axes propres coïncident avec ceux de la fibre sensible.

La sortie du transducteur 23 est connectée à une entrée B de l'analyseur 7. L'ensemble des fibres connectées entre les points A et B constitue donc un système orienté. Dans le mode de réalisation de la figure 8, l'analyseur est disposé dans la tête de capteur 20 et fournit des signaux lumineux sur deux voies d'analyse séparées. L'analyseur 7 est connecté par des fibres de sortie 9a et 9b à un système de détection optoélectronique 6, localisé dans l'ensemble 21. Les fibres 9a et 9b peuvent être des fibres multimode standards. Le système de détection 6 comporte deux détecteurs élémentaires 6a et 6b, associés chacun à une voie d'analyse et fournissant respectivement des signaux électroniques Ia et Ib au circuit de traitement 10.

Entre les points A et B les deux composantes de l'onde optique selon les axes propres du système orienté subissent un déphasage $\Phi$total constitué par la combinaison du déphasage électro-optique $\Phi$eo et d'un déphasage intrinsèque $\Phi$i du à la biréfringence intrinsèque des fibres du système orienté. Lorsque les critères d'alignement entre les axes propres de la fibre sensible 12 et le champ $\vec{E}$ sont respectés, ces déphasages s'additionnent :

$$\Phi total = \Phi i + \Phi eo \tag{12}$$

$\Phi$eo est proportionnel à la tension à mesurer, conformément à l'équation (11), et $\Phi$i peut s'écrire :

$$\Phi i = \delta\beta i \, L_{AB} \tag{13}$$

où $\delta\beta i$ est la biréfringence intrinsèque des fibres et $L_{AB}$ la longueur des fibres, entre A et B.

Pour maximiser la sensibilité de la mesure du déphasage, l'onde lumineuse incidente est linéairement polarisée en A à 45° des axes propres du système orienté. La linéarité et la sensibilité de la mesure dépendent alors de l'état de polarisation de l'onde lumineuse au point B, elle-même fonction à la fois de l'état de polarisation initial, au point A, et de la biréfringence intrinsèque du système orienté.

La tension à mesurer étant du type tension alternative, le déphasage $\Phi$eo peut s'écrire sous la forme :

$$\Phi eo = K \sin\omega t \tag{14}$$

$\omega$ étant la pulsation de la tension (V2 - V1), généralement de fréquence 50 Hz ou 60 Hz environ.

Les détecteurs 6a et 6b délivrent chacun un signal électrique proportionnel à l'intensité lumineuse reçue, de la forme :

$$I = \gamma \frac{I_o}{2}[1 + \sin 2\theta \cos(F_i + K\sin\omega t)] \tag{15}$$

où $\theta$ est l'orientation de l'analyseur pour chaque voie d'analyse, orientation exprimée dans le système XZ d'axes propres de la fibre sensible. $\gamma$ est un terme représentatif des pertes optiques, localisées ou distribuées, ayant lieu au cours de la propagation de l'onde lumineuse entre la source (1) et l'analyseur (7).

Dans le mode de réalisation représenté, $\theta a = 45°$ pour une première voie d'analyse et $\theta b = 135°$ pour une seconde voie d'analyse. Ceci peut-être réalisé, de manière classique, à l'aide d'un cube analyseur ou avec un coupleur en forme de Y, et deux analyseurs. Alors $\sin 2\theta = +/-1$. Si, de plus la biréfringence intrinsèque est telle que $\Phi i = (2p + 1)\,\pi/2$, avec p entier, alors les variations de Ia et Ib dues à l'effet électro-optique sont maximales. En effet, pour les deux voies d'analyse, l'équation (15) s'écrit respectivement :

$$Ia = \gamma \frac{I_o}{2}[1 + \sin(K\sin wt)] \tag{16}$$

$$Ib = \gamma \frac{I_o}{2}[1 - \sin(K\sin\omega t)] \tag{17}$$

Le circuit de traitement 10 de la figure 8, permet de s'affranchir des variations de l'intensité Io de la source optique (1). Il reçoit en entrée les signaux Ia et Ib et calcule le rapport :

$$(Ia - Ib) / (Ia + Ib) = \sin(K\sin\omega t) = \sin \Phi eo \tag{18}$$

Ce rapport est bien indépendant de la valeur $I_o$. Puis, le circuit de traitement (10) réalise la fonction Arcsin et fournit, en conséquence, un signal S représentatif du déphasage électrooptique $\Phi$eo, et donc de la tension à mesurer.

L'hypothèse retenue ci-dessus pour la valeur de $\Phi$i permet d'obtenir une valeur optimale de $\Phi$eo en terme de linéarité et de sensibilité. Or, la biréfringence intrinsèque en réalité, variable au cours du temps. Cette variation, fonction des contraintes extérieures appliquées au capteur, comme la température, les vibrations mécaniques, etc., est une variation lente par rapport à la fréquence de variation (50 Hz environ) de $\Phi$eo Les variations de $\Phi$ι évoluent lentement en fonction du temps à une fréquence f< < 50 Hz.

Selon le mode de réalisation préférentiel, représenté à la figure 8, le point de fonctionnement du capteur est stabilisé de manière à garantir à tout instant les conditions les plus favorables en terme de sensibilité et de linéarité de la mesure. Ceci est réalisé, sur la figure 8, par un asservissement basse-fréquence de $\Phi$i de manière à ce que

$\Phi i = (2p + 1) \, \pi/2$. Cette condition se traduit au repose, c'est à dire pour une tension à mesurer nulle, donc un déphasage $\Phi eo$ nul, par un état de polarisation en B parfaitement circulaire. Les intensités analysées à des angles différents par l'analyseur 7 sont alors identiques et les signaux utilisés pour extraire S peuvent être utilisés pour l'asservissement du point de fonctionnement du capteur. Un circuit 25 de contrôle et de commande de l'état de polarisation, connecté au circuit de traitement 10, commande un dispositif 26 de régulation du déphasage intrinsèque $\Phi i$ entre les points A et B. Le dispositif 26 agit par déformation d'une zone localisée d'une des fibres du système orienté. Sur la figure 8, la zone déformée est située sur la fibre optique d'entrée 3 à maintien de polarisation connectée à la fibre sensible 12. Il est également possible d'agir sur une fibre connectée en sortie de la fibre sensible, ou directement, dans le transducteur, sur la fibre sensible. Le mode de réalisation représenté sur la figure 8 est préféré dans la mesure où il permet d'isoler électriquement totalement la tête de capteur 20 de l'ensemble 21, assurant ainsi l'isolation galvanique entre l'électronique et la tête du capteur.

Sur la figure 8, le circuit de traitement 10 comporte deux circuits distincts 10a et 10b, connectés en série et réalisant respectivement les fonctions (Ia - Ib) / (Ia + Ib) et Arcsin. Le circuit de contrôle 25 est connecté à la sortie du circuit 10a et commande le dispositif de manière à ce que les composantes basse-fréquence (f< < 50 Hz) de Ia et Ib soient identiques, c'est à dire que la composante basse-fréquence de (Ia - Ib) soit nulle.

L'invention n'est pas limitée aux modes de réalisation particuliers décrits et représentés.

Ainsi, le transducteur idéal se compose d'une fibre optique sensibilisée de manière uniforme sur toute sa longueur. Néanmoins, pour des raisons de facilité de fabrication, le transducteur peut comporter plusieurs zones sensibles, de préférence jointives et de même sensibilité. Il peut également être constitué par un assemblage de fibres élémentaires, comportant des zones sensibles, disposées bout à bout. Dans tous les cas les axes propres de tous les éléments de fibre seront alignés de manière à conserver un ensemble ayant des axes propres définis.

Afin de réaliser au mieux l'intégrale du champ électrique rayonné entre deux points entre lesquels est appliquée la tension à mesurer, les extrémités du transducteur sont positionnées au plus près de ces points. Néanmoins, pour des raisons de mise en oeuvre pratique, il est possible de disposer le transducteur de façon à ne réaliser qu'une partie de l'intégrale du champ rayonné. Dans ce cas le transducteur est de préférence disposé dans les régions où le champ est le plus important, de manière à limiter l'erreur de mesure.

Sur la figure 8, le système orienté comportant des axes propres fixes va du point A, situé dans l'ensemble 21 au point B, situé dans la tête de capteur. L'analyseur 7 peut éventuellement être disposé dans l'ensemble 21. Dans ce cas le signal de sortie du transducteur 23 est transmis jusqu'à l'ensemble 21 par une fibre qui doit posséder les axes propres du système orienté. Ceci peut-être réalisé par une fibre à maintien de polarisation connectée à la sortie du transducteur ou par une partie non sensibilisée de la fibre sensible (12) constituant le transducteur.

Il est également possible que le point A soit reporté dans la tête de capteur 20. Dans ce cas la fibre optique d'entrée 3 peut-être de type standard. La condition d'orientation à 45° de l'onde polarisée par rapport aux axes propres du transducteur peut alors être assurée au point A par un système de contrôle actif appropriée, délocalisé, situé en amont du point A et de la fibre d'entrée 3, dans l'ensemble 21. Dans ce cas on réalise un double asservissement de manière à garantir à la fois la condition d'injection d'une onde polarisée à 45° et le contrôle du point de fonctionnement, cette double condition se traduisant toujours par un état parfaitement circulaire en sortie pour une tension appliquée nulle.

Dans la description ci-dessus l'asservissement du point de fonctionnement est réalisé par un contrôle du déphasage intrinsèque. L'état de polarisation en sortie du transducteur est fonction du déphasage électro-optique à mesurer, du déphasage du à la biréfringence intrinsèque des fibres et de l'état de polarisation de l'onde optique en entrée du transducteur. Les variations de la tension à mesurer, et donc du déphasage électro-optique ont une fréquence supérieure aux variations des autres facteurs. Ainsi, l'asservissement du point de fonctionnement agit sur l'état de polarisation de l'onde optique en entrée du transducteur.

L'analyse du déphasage électro-optique peut-être réalisée au moyen d'une méthode interférométrique en lumière blanche. Dans ce cas, la source (1) est une source polychromatique et l'analyse consiste en une reconnaissance du spectre d'interférence.

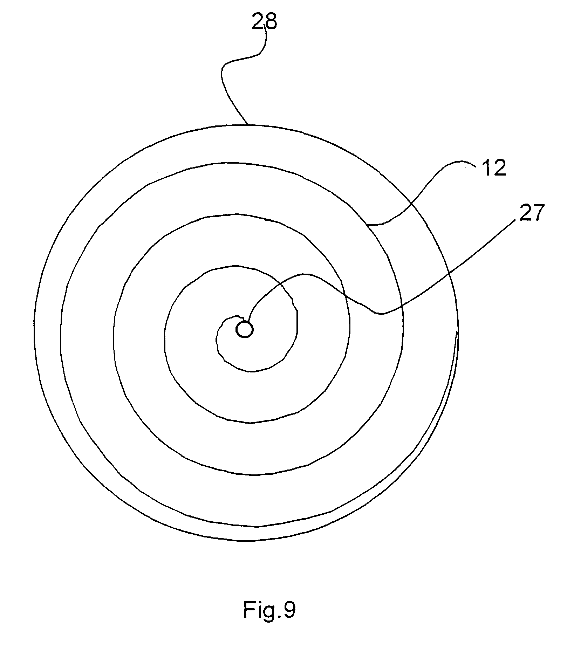

Sur la figure 4, le bobinage de la fibre est un bobinage de type hélicoïdal. L'invention n'est cependant pas limitée à ce type de bobinage. A titre d'exemple, pour la mesure de la tension entre un conducteur central 27 et une enveloppe cylindrique 28 dans une cellule blindée, la fibre 12 est de préférence disposée en spirale entre le conducteur et l'enveloppe (Fig. 9).

## Revendications

1. Capteur de tension électro-optique, comportant des moyens (1, 14) de production d'une onde lumineuse incidente, un transducteur électro-optique (23) présentant un effet électro-optique d'ordre 2 disposé dans un champ électrique ($\vec{E}$) généré par une tension (V; V2-V1) à mesurer et comportant une entrée recevant l'onde lumineuse incidente et une sortie fournissant une onde lumineuse de sortie, des moyens isolants (15) de support du transducteur, des moyens (6, 7; 6a, 6b) de détection optoélectroniques connectés à la sortie du transducteur, et des moyens électroniques de traitement (10) connectés aux moyens de détection capteur caractérisé en ce que le transducteur (23) comporte une fibre optique (12) ayant au moins une zone sensible ou sensibilisée au champ électrique et présentant un effet électro-optique d'ordre 2, ladite fibre étant disposée sous forme d'un bobinage entre deux points entre lesquels la tension à mesurer est appliquée.

2. Capteur selon la revendication 1, caractérisé en ce que le bobinage est un bobinage hélicoïdal,

3. Capteur selon la revendication 1, caractérisé en ce que le bobinage est constitué par une spirale.

4. Capteur selon l'une des revendications 1 et 2, caractérisé en ce qu'il comporte des moyens d'homogénéisation (16, 17) pour homogénéiser la distribution des lignes de champ électrique dans la région où sont disposées les zones sensibles de la fibre optique (12).

5. Capteur selon la revendication 4, caractérisé en ce que les moyens d'homogénéisation comportent deux électrodes planes, parallèles, aux bornes desquelles est appliquée la tension à mesurer.

6. Capteur selon l'une quelconque des revendications 1 à 5, caractérisé en ce que la fibre optique (12) est sensibilisée au champ électrique de manière continue et uniforme sur toute sa longueur.

7. Capteur selon l'une des revendications 1 à 6, caractérisé en ce que les extrémités de la fibre optique sont placées le plus près possible des deux points entre lesquels la tension à mesurer est appliquée.

8. Capteur selon l'une quelconque des revendications 1 à 5, caractérisé en ce que la fibre optique (12) est constituée par un assemblage de fibres élémentaires, comportant des zones sensibles, disposées bout à bout.

9. Capteur selon l'une quelconque des revendications 1 à 8, caractérisé en ce que les zones sensibles de la fibre optique (12) sont sensibilisées par un procédé de polarisation sous champ.

10. Capteur selon l'une quelconque des revendications 1 à 9, caractérisé en ce que le bobinage est régulier et la fibre (12) comporte des axes propres (X, Z) ayant une orientation sensiblement constante par rapport au champ électrique($\vec{E}$).

11. Capteur selon la revendication 10, caractérisé en ce que la fibre optique (12) comporte des moyens externes de reconnaissance des axes propres (X, Z) de la fibre.

12. Capteur selon la revendication 11 caractérisé en ce que les moyens de reconnaissance des axes propres de la fibre (12) comportent un méplat longitudinal (22) ayant une orientation prédéterminée par rapport aux axes propres (X, Z) de la fibre.

13. Capteur selon l'une des revendications 1 à 2, caractérisé en ce que les moyens isolants de support du transducteur comportent un cylindre diélectrique (15) sur lequel est bobinée la fibre optique (12).

14. Capteur selon la revendication 13, caractérisé en ce que le cylindre diélectrique (15) supporte à ses extrémités des électrodes planes (16, 17), circulaires, dont le diamètre est supérieur au diamètre du cylindre et entre lesquelles est appliquée la tension à mesurer.

15. Capteur selon l'une des revendication 1 à 14, caractérisé en ce que la fibre optique (12) possède une biréfringence intrinsèque élevée.

16. Capteur selon l'une quelconque des revendications 1 à 15, caractérisé en ce que les moyens de production de l'onde lumineuse incidente comportent des moyens de polarisation (14), les moyens de détection optoélectroniques comportant des moyens (7) d'analyse polarimètrique de l'onde lumineuse de sortie du transducteur (23).

17. Capteur selon la revendication 16, caractérisé en ce qu'il comporte des moyens (25, 26) de contrôle et de commande basse-fréquence de l'état de la polarisation de l'onde lumineuse afin d'asservir le point de fonctionnement du capteur.

18. Capteur selon la revendication 17, caractérisé en ce que les moyens (25, 26) de contrôle et de commande de l'état de polarisation sont connectés à la sortie des moyens (6) de détection optoélectroniques.

**19.** Capteur selon l'une des revendications 17 et 18, caractérisé en ce que les moyens (25, 26) de contrôle et de commande de l'état de polarisation comportent des moyens de déformation d'une zone localisée du transducteur (23).

**20.** Capteur selon l'une des revendications 17 et 18, caractérisé en ce que les moyens (25, 26) de contrôle et de commande de l'état de polarisation comportent des moyens (26) de déformation d'une fibre optique (3) connectée en série avec la fibre optique sensible (12) entre les moyens (1) de production de l'onde lumineuse incidente et les moyens (6) de détection optoélectroniques.

Fig. 1   (ART ANTERIEUR)

Fig. 2

Fig. 3

Fig. 4

Fig. 5

Fig. 6

Fig. 7

Fig. 8

Fig.9

**EP 0 806 675 A1**

Office européen
des brevets

**RAPPORT DE RECHERCHE EUROPEENNE**

Numero de la demande

EP 97 41 0045

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| A | US 3 810 013 A (SIEMENS) <br> * figure 1 * <br> --- | 1 | G01R15/24 <br> G01R1/07 |
| A | IEEE TRANS. ON POWER DELIVERY, <br> vol. 8, no. 4, Octobre 1993, NEW YORK,US, <br> pages 1721-1726, XP000422594 <br> K. KUROSAWA ET AL.: "development of an optical instrument transformer for dc voltage measurement" <br> * figure 2 * <br> ----- | 1 | |

DOMAINES TECHNIQUES
RECHERCHES (Int.Cl.6)

G01R

Le présent rapport a été établi pour toutes les revendications

| Lieu de la recherche | Date d'achèvement de la recherche | Examinateur |
|---|---|---|
| LA HAYE | 30 Juin 1997 | Hoornaert, W |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)